(19) Europäisches Patentamt
European Patent Office
Office européen des brevets

(11) EP 1 555 757 A1

(12) DEMANDE DE BREVET EUROPEEN

(43) Date de publication:
20.07.2005 Bulletin 2005/29

(51) Int Cl.$^7$: H03L 7/23, H04L 27/36

(21) Numéro de dépôt: 04029810.1

(22) Date de dépôt: 16.12.2004

(84) Etats contractants désignés:
AT BE BG CH CY CZ DE DK EE ES FI FR GB GR HU IE IS IT LI LT LU MC NL PL PT RO SE SI SK TR
Etats d'extension désignés:
AL BA HR LV MK YU

(30) Priorité: 16.01.2004 FR 0400414

(71) Demandeur: STMicroelectronics S.A.
92210 Montrouge (FR)

(72) Inventeurs:
• Ramet, Serge
38100 Grenoble (FR)
• Jouen, Philippe
38640 Claix (FR)
• Triaire, Pascal
38560 Haute-Jarrie (FR)

(74) Mandataire: Marchand, André
OMNIPAT,
24 Place des Martyrs de la Résistance
13100 Aix-en-Provence (FR)

(54) **Circuit intégré RF comprenant un synthétiseur de fréquence peu sensible à l'effet d'accrochage en fréquence**

(57) L'invention concerne un circuit intégré RF comprenant un synthétiseur de fréquence et un modulateur QAM (TXCT) pour moduler un signal de bande de base de fréquence $F_{BB}$, le synthétiseur de fréquence fournissant au modulateur QAM un signal de sortie de fréquence F1 ajustable avec un pas en fréquence $\Delta F1$, pour former un signal de porteuse du modulateur QAM. Selon l'invention, le synthétiseur de fréquence est un synthétiseur de fréquence à effet de vernier comprenant un synthétiseur de fréquence auxiliaire (40) fournissant un signal auxiliaire de fréquence F2 ajustable avec un pas en fréquence $\Delta F2$ et un synthétiseur de fréquence principal (30) ayant une bande passante de boucle à verrouillage de phase au moins deux fois supérieure au pas en fréquence $\Delta F2$ du signal auxiliaire.

Fig. 5

EP 1 555 757 A1

**Description**

La présente invention concerne les synthétiseurs de fréquence comprenant un oscillateur contrôlé en tension et une boucle à verrouillage de phase.

La présente invention concerne plus particulièrement un circuit intégré RF comprenant un synthétiseur de fréquence et un modulateur QAM pour moduler un signal de bande de base de fréquence $F_{BB}$, le synthétiseur de fréquence fournissant au modulateur QAM un signal de sortie de fréquence F1 ajustable avec un pas en fréquence $\Delta$F1, pour former un signal de porteuse du modulateur QAM.

La présente invention concerne également un procédé pour réduire l'effet d'accrochage en fréquence dans un circuit intégré RF comprenant un synthétiseur de fréquence et un modulateur QAM pour moduler un signal de bande de base de fréquence $F_{BB}$, le synthétiseur de fréquence fournissant au modulateur QAM un signal de sortie de fréquence F1 ajustable avec un pas en fréquence $\Delta$F1, pour former un signal de porteuse du modulateur QAM, l'effet d'accrochage en fréquence étant dû à l'injection dans le synthétiseur de fréquence de signaux parasites issus du modulateur QAM.

Dans les circuits RF combinant un synthétiseur de fréquence et un modulateur QAM (quadrature amplitude modulation), des phénomènes de fuite de signaux fondamentaux, harmoniques ou de mélange issus du modulateur QAM dégradent les performances de l'oscillateur contrôlé en tension présent dans le synthétiseur de fréquence, en raison d'un effet d'accrochage en fréquence appelé "injection pulling" ou "injection locking".

La présente invention vise la diminution de l'effet d'accrochage en fréquence dans de tels circuits RF.

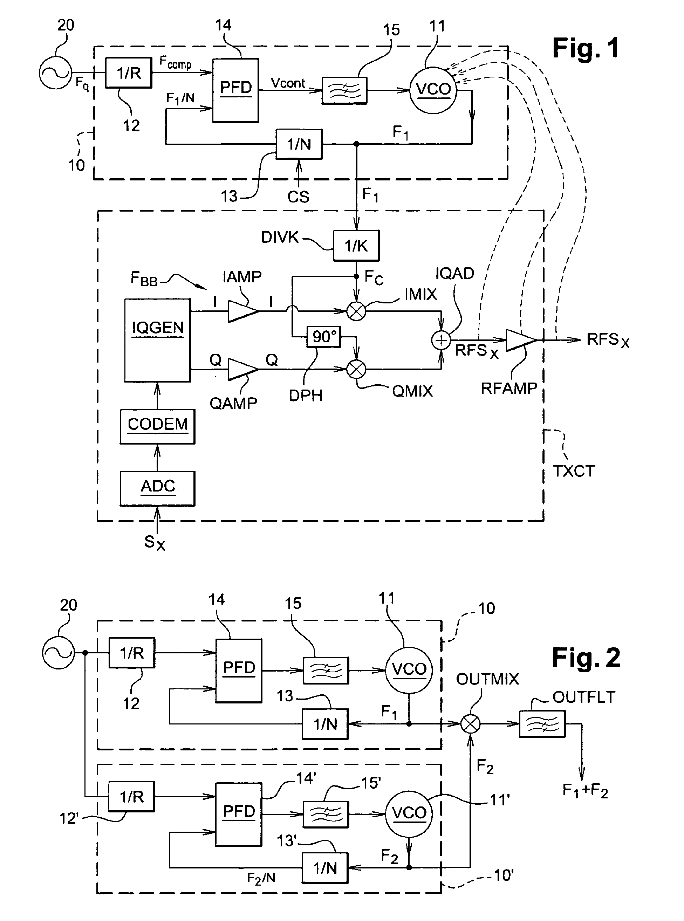

La figure 1 représente un circuit intégré RF de radiotéléphonie dans lequel l'effet d'accrochage en fréquence constitue un problème fondamental pour l'homme de l'art. Ce circuit intégré RF comprend un synthétiseur de fréquence 10 et un modulateur QAM, le modulateur QAM formant ici un circuit d'émission radiofréquence TXCT.

Le synthétiseur de fréquence 10 est piloté par un oscillateur à quartz 20 et fournit au circuit TXCT un signal de sortie de fréquence F1 ajustable avec un pas en fréquence déterminé. Typiquement, la fréquence F1 est de 3,6 GHz et est ajustable de 3,2 GHz à 4 GHz avec un pas de 400 KHz.

Dans ce qui suit, on désigne par "rang" d'un diviseur de fréquence le coefficient de division du diviseur de fréquence considéré.

Le synthétiseur de fréquence 10 comprend un oscillateur contrôlé en tension 11 (VCO), un diviseur de fréquence 12 de rang R et une boucle à verrouillage de phase ("Phase Locked Loop"). La boucle à verrouillage de phase comprend un diviseur de fréquence 13 de rang N, un comparateur de phase 14 (PFD) et un filtre de boucle 15 de type passe-bas. Le rang N du diviseur de fréquence 13 est programmable au moyen d'un signal CS ("Channel Selection") appliqué sur une entrée de commande du diviseur de fréquence.

Le signal de sortie de fréquence F1 est fournit par l'oscillateur 11, et est renvoyé à l'entrée du diviseur de fréquence 13. Celui-ci fournit un signal de fréquence F1/N qui est appliqué sur une première entrée du comparateur de phase 14. Le comparateur de phase reçoit sur une seconde entrée un signal de comparaison de fréquence Fcomp, fourni par le diviseur de fréquence 12 dont l'entrée reçoit un signal de fréquence Fq fourni par l'oscillateur à quartz 20 (Fcomp=Fq/R). La sortie du comparateur de phase 14 fournit un signal de contrôle Vcont qui est appliqué à l'oscillateur 11 par l'intermédiaire du filtre de boucle 15. Le signal de fréquence F1 est ainsi asservi en fréquence et en phase, et la fréquence F1 est égale à N*Fcomp, Fcomp représentant le pas en fréquence du signal de sortie. Typiquement Fcomp est de l'ordre de 400 KHz pour une fréquence de bande de base $F_{BB}$ de 200 KHz, et N varie entre 8000 et 10000.

Le circuit TXCT ou modulateur QAM reçoit un signal analogique $S_x$ ainsi que le signal de fréquence F1, et fournit un signal d'antenne RFSx modulé en phase. Le signal RFSx est appliqué à une antenne RF qui n'est pas représentée sur la figure.

Le signal de fréquence F1 est appliqué à un diviseur de fréquence DIVK de rang K, dont la sortie fournit une porteuse Fc du canal radio, Fc étant égale à F1/K, K étant généralement égal à 2 pour la bande DCS (1,8 GHz) et à 4 pour la bande GSM (900 MHz).

Le signal Sx est numérisé par un convertisseur ADC, puis est appliqué à un modem codeur CODEM puis est encore appliqué à un processeur IQGEN. Le processeur IQGEN fournit, dans la bande de base de fréquence $F_{BB}$, un signal en phase I et un signal en quadrature Q à moduler avec la porteuse Fc. Le signal I est appliqué sur une entrée d'un mélangeur IMIX par l'intermédiaire d'un amplificateur IAMP, et le signal Q est appliqué sur une entrée d'un mélangeur QMIX par l'intermédiaire d'un amplificateur QAMP. Le mélangeur IMIX reçoit sur une autre entrée la porteuse Fc et le mélangeur QMIX reçoit sur une autre entrée la porteuse Fc déphasée de 90°, fournie par un déphaseur DPH. Les sorties des mélangeurs IMIX, QMIX sont appliquées à un additionneur IQAD qui fournit le signal modulé RFSx. Le signal RFSx est appliqué à un amplificateur de sortie RFAMP dont la sortie fournit le signal d'antenne.

Le signal Sx contient généralement des données à transmettre, par exemple une voix codée, et présente un spectre de fréquences représentatif du schéma de modulation prévu par la norme mise en oeuvre (par exemple GMSK en GSM). En considérant à titre d'exemple que le signal Sx est une tonalité unique ("single tone"), le circuit IQGEN fournit alors deux sinusoïdes pures en quadrature I = cos ($F_{BB}$) et Q = sin ($F_{BB}$). Le résultat de la modulation de phase IQ est dans ce cas une tonalité unique de fréquence Fc+$F_{BB}$ dont la composante image Fc-$F_{BB}$ est en principe supprimée par la modulation en quadrature, et dont la porteuse Fc est également supprimée, à tout le moins fortement atténuée.

En raison d'imperfections dans le circuit de modulation et dans l'amplificateur de sortie RFAMP, ou non-linéarités, le signal RFSx comprend, en sus de la composante utile H1 de fréquence $Fc+F_{BB}$, des composantes harmoniques H2, H3, H4,... Parmi ces composantes, l'une au moins est proche de la fréquence d'oscillation F1 de l'oscillateur 11 du synthétiseur de fréquence 10 et forme une composante parasite qui est réinjectée dans l'oscillateur par divers chemins parasites (couplage électromagnétique et propagation dans le substrat). Il s'agit notamment de la deuxième harmonique H2 lorsque le diviseur de fréquence DIVK est un diviseur par 2 (bande DCS) ou de la quatrième harmonique H4 lorsque le diviseur de fréquence DIVK est un diviseur par 4 (bande GSM). En effet, quand K=2 la fréquence de la deuxième harmonique H2 est égale à $2Fc+2F_{BB}$ (soit $F1 + 2F_{BB}$) et est très proche de la fréquence centrale F1 de l'oscillateur 11 car la fréquence de bande de base $F_{BB}$ est faible devant la porteuse Fc. De même, quand K=4 la quatrième harmonique H4 présente une fréquence de $4Fc+4F_{BB}$ (soit $F1 + 4F_{BB}$) qui est proche de la fréquence centrale de l'oscillateur 11. Cette composante parasite peut également être la composante utile H1 elle-même, dans un circuit où K est égal à 1.

Il est connu que l'injection involontaire de cette composante parasite dans le coeur de l'oscillateur dégrade les performances de ce dernier. En effet, la boucle à verrouillage de phase n'arrive pas à supprimer totalement la composante parasite qui se trouve donc réinjectée dans le signal de sortie de l'oscillateur contrôlé en tension. Il s'ensuit un effet d'accrochage en fréquence, car la composante parasite réinjectée dans le signal de sortie de l'oscillateur revient ensuite dans le coeur de l'oscillateur en passant par des chemins parasites, est réinjectée de nouveau dans le signal de sortie, et ainsi de suite.

Diverses solutions sont connues pour pallier cet inconvénient.

Il est tout d'abord fréquent que l'oscillateur contrôlé en tension soit réalisé sur une microplaquette de silicium distincte de celle portant le circuit TXCT. Cette solution est toutefois complexe à mettre en oeuvre et grève le prix de revient des circuits RF, ce qui se répercute en bout de chaîne sur le prix de vente des téléphones mobiles. Ainsi, on tend au contraire, à l'heure actuelle, à intégrer l'oscillateur sur la microplaquette de silicium portant le circuit de transmission TXCT. On envisage également d'intégrer sur cette même microplaquette de silicium l'amplificateur de sortie RFAMP, qui n'est pas linéaire et constitue une source importante d'harmoniques parasites de forte amplitude.

Une autre solution consiste à décaler la fréquence de la porteuse Fc relativement à la fréquence centrale de l'oscillateur contrôlé en tension. Ainsi, les systèmes hétérodynes utilisent plusieurs oscillateurs contrôlés en tension et plusieurs mélangeurs en cascade, et un étage de prémodulation utilisant une fréquence intermédiaire IF. Dans l'étage de sortie, la fréquence porteuse du signal modulé est décalée relativement à la fréquence propre de l'oscillateur contrôlé en tension, et les signaux susceptibles d'interférer avec l'oscillateur contrôlé en tension sont harmoniques et/ou des produits de mélange de haut rang qui sont fortement atténués. Les systèmes hétérodynes sont toutefois complexes et coûteux à réaliser, ainsi que les mélangeurs et les filtres supplémentaires.

Encore une autre solution consiste à prévoir un synthétiseur en fréquence fournissant un signal de sortie dont la fréquence est décalée relativement à la fréquence centrale de l'oscillateur contrôlé en tension.

La figure 2 représente un circuit conforme à cette solution. Le circuit représenté comprend deux synthétiseurs de fréquence 10, 10' pilotés par le même oscillateur à quartz 20. Chaque synthétiseur de fréquence est d'une structure semblable à celui de la figure 1 et comprend un oscillateur contrôlé en tension 11, 11', un diviseur de fréquence 12, 12' de rang R, un diviseur de fréquence 13, 13' de rang N, un comparateur de phase 14, 14' et un filtre de boucle 15, 15'. Chaque oscillateur contrôlé en tension 11, 11' fournit un signal de fréquence F1, respectivement F2. Les deux signaux sont appliqués à un mélangeur OUTMIX qui fournit un signal de sortie comprenant une composante additive de fréquence F1+F2 et une composante soustractive de fréquence F2-F1. Le signal de sortie du mélangeur est appliqué à un filtre OUTFLT qui supprime l'une des composantes, par exemple la composante soustractive, pour ne conserver que l'autre composante en tant que signal de sortie du circuit. Ainsi, les signaux harmoniques du signal de sortie, de fréquence F1+F2, sont éloignés des fréquences centrales de chacun des oscillateurs contrôlés en tension, et leur effet perturbateur est réduit.

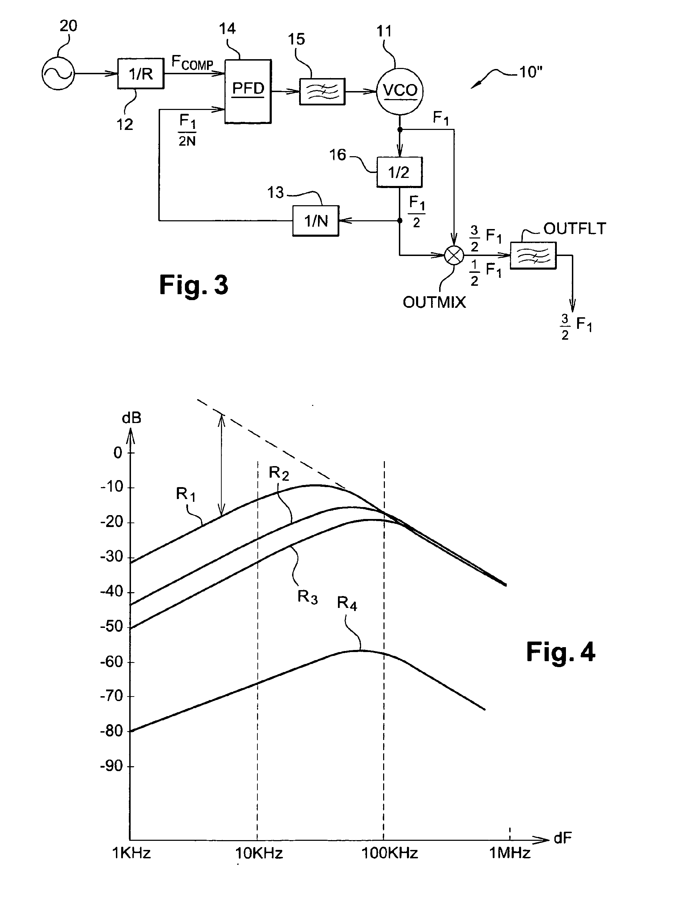

Dans le même ordre d'idée, la figure 3 représente un synthétiseur de fréquence 10" tel que décrit par le brevet US63211074. Le synthétiseur de fréquence est piloté par un oscillateur à quartz 20 et comprend, comme celui de la figure 1, un oscillateur contrôlé en tension 11, un diviseur de fréquence 12, un diviseur de fréquence 13, un comparateur de phase 14 et un filtre de boucle 15. Un diviseur de fréquence 16 de rang 2 est ici inséré dans la boucle à verrouillage de phase, entre la sortie de l'oscillateur 11 et l'entrée du diviseur de fréquence 13. Le signal de sortie de l'oscillateur 11, de fréquence F1, est appliqué sur une entrée d'un mélangeur de sortie OUTMIX dont une autre entrée reçoit le signal fournit par le diviseur de fréquence 16, de fréquence F1/2. Le signal de sortie du mélangeur comprend ainsi une composante additive de fréquence F1 + F1/2 soit 3/2*F1 et une composante soustractive de fréquence F1 - F1/2 soit F1/2. Un filtre de sortie OUTFLT supprime la composant soustractive. Ainsi, les harmoniques du signal de sortie ont des fréquences (3*F1, 4,5*F1, 6*F1...)

éloignés de la fréquence centrale F1 de l'oscillateur 11, et leur effet perturbateur est réduit.

L'inconvénient de ces deux synthétiseurs de fréquence est que le signal de sortie est fourni par un mélangeur, et qu'il est nécessaire de filtrer fortement la sortie du mélangeur pour ne conserver que la fréquence utile. Un tel filtrage nécessite le plus souvent un composant externe, et augmente le prix de revient et la complexité du circuit intégré RF.

Ainsi, la présente invention vise un circuit intégré RF comprenant un synthétiseur de fréquence et un modulateur QAM, dans lequel le synthétiseur de fréquence est peu sensible aux signaux parasites issus du modulateur QAM, mais dans lequel le signal de sortie du synthétiseur de fréquence n'est pas fourni par un mélangeur.

Pour atteindre cet objectif, la présente invention repose sur une étude approfondie des mécanismes de perturbation intervenant dans un oscillateur contrôlé en tension. Au terme de cette étude, on a constaté que la sensibilité aux signaux parasites de l'oscillateur contrôlé en tension est d'autant plus faible que la bande passante BW de la boucle à verrouillage de phase est étendue.

Toutefois, une extension de la bande passante BW de la boucle à verrouillage de phase ne peut être envisagée dans un synthétiseur de fréquence classique, car il est de règle que cette bande passante BW ne doit pas excéder environ 1/10 de la fréquence de comparaison Fcomp (soit le pas en fréquence). Cette règle vise à garantir la stabilité de la boucle à verrouillage de phase. Avec un pas en fréquence de 400 KHz (valeur typique à l'heure actuelle en radiotéléphonie GSM ou DCS) cette contrainte limite la bande passante de boucle à 40 ou 50 KHz.

Pour contourner cet obstacle, une idée de l'invention est d'utiliser un synthétiseur de fréquence à effet de vernier en tant que synthétiseur de fréquence fournissant au modulateur QAM le signal de fréquence F1 permettant de former le signal de porteuse Fc.

Les synthétiseurs de fréquence à effet de vernier sont utilisés dans l'état de la technique en tant que modulateurs de phase. Ils comprennent un synthétiseur de fréquence principal et un synthétiseur de fréquence auxiliaire, ce dernier fournissant au synthétiseur de fréquence principal un signal auxiliaire de fréquence F2, le synthétiseur de fréquence principal fournissant un signal principal de fréquence F1. Le pas en fréquence $\Delta F1$ du signal principal F1 est fonction du pas en fréquence $\Delta F2$ du signal auxiliaire de fréquence F2, ce qui caractérise l'effet de vernier. Dans l'état de la technique, le signal de fréquence auxiliaire F2 est modulé avec le signal de bande de base de fréquence $F_{BB}$, et cette modulation se retrouve dans le signal de sortie de fréquence F1 du synthétiseur de fréquence principal, le synthétiseur de fréquence à effet de vernier formant ainsi un modulateur de phase.

Ainsi, la présente invention propose d'utiliser un synthétiseur de fréquence à effet de vernier en tant que synthétiseur de fréquence "ordinaire", et non en tant que modulateur de phase.

En effet étant donné que, dans un tel synthétiseur de fréquence, le pas en fréquence du signal principal F1 est fonction du pas en fréquence du signal auxiliaire F2, il devient possible d'appliquer au synthétiseur de fréquence principal un signal de comparaison ayant une fréquence élevée par rapport aux 400 kHz classiques, et de prévoir dans le synthétiseur de fréquence principal une boucle à verrouillage de phase ayant une bande passante étendue nettement supérieure à 1/10 du pas en fréquence du signal auxiliaire. Egalement, selon un autre aspect de l'invention, la fréquence F2 du synthétiseur de fréquence auxiliaire est choisie suffisamment éloignée de la fréquence F1 pour ne pas être sensible aux parasites émis par le modulateur QAM.

Plus particulièrement, la présente invention prévoit un circuit intégré RF du type cité ci-dessus, dans lequel le synthétiseur de fréquence est un synthétiseur de fréquence à effet de vernier comprenant un synthétiseur de fréquence auxiliaire fournissant un signal auxiliaire de fréquence F2 ajustable avec un pas en fréquence $\Delta F2$, et un synthétiseur de fréquence principal fournissant le signal de sortie de fréquence F1 et comprenant une boucle à verrouillage de phase comportant des moyens de mélange du signal de sortie de fréquence F1 avec le signal auxiliaire de fréquence F2, de sorte que le pas en fréquence $\Delta F1$ du signal de sortie est égal ou proportionnel au pas en fréquence $\Delta F2$ du signal auxiliaire, et dans lequel la bande passante de la boucle à verrouillage de phase du synthétiseur de fréquence principal est au moins deux fois supérieure au pas en fréquence $\Delta F2$ du signal auxiliaire.

Selon un mode de réalisation, l'écart entre les fréquences F2 et F1 est supérieur à quelques dizaines de fois la fréquence de bande de base $F_{BB}$.

Selon un mode de réalisation, le synthétiseur de fréquence principal comprend un oscillateur contrôlé en tension fournissant le signal de sortie de fréquence F1, et un comparateur de phase recevant en entrée un signal de comparaison de fréquence déterminée et une composante soustractive de fréquence F2-F1 fournie par les moyens de mélange du signal de sortie de fréquence F1 avec le signal auxiliaire de fréquence F2.

Selon un mode de réalisation, la fréquence du signal de comparaison est au moins 20 fois supérieure au pas en fréquence $\Delta F2$ du signal auxiliaire.

Selon un mode de réalisation, le signal de comparaison est un signal de fréquence fixe, de sorte que le pas en fréquence $\Delta F1$ du signal de sortie est égal au pas en fréquence $\Delta F2$ du signal auxiliaire.

Selon un mode de réalisation, le synthétiseur de fréquence principal comprend un diviseur de fréquence de rang P recevant en entrée le signal auxiliaire et fournissant le signal de comparaison, de sorte que le signal de sortie présente un pas en fréquence $\Delta F1$ égal au pas en fréquence $\Delta F2$ du signal auxiliaire multiplié par un terme qui est fonction de P.

Selon un mode de réalisation, la fréquence F2-F1 de la composante soustractive est de l'ordre de 300 MHz.

Selon un mode de réalisation, le synthétiseur de fréquence auxiliaire comprend un oscillateur contrôlé en tension et une boucle à verrouillage de phase, l'oscillateur contrôlé en tension du synthétiseur de fréquence auxiliaire fournissant le signal auxiliaire, la boucle à verrouillage de phase du synthétiseur de fréquence auxiliaire permettant d'ajuster la fréquence F2 du signal auxiliaire.

Selon un mode de réalisation, le synthétiseur de fréquence auxiliaire est piloté par un oscillateur à quartz relié à un diviseur de fréquence de rang R qui fournit un signal de comparaison de fréquence déterminée à la boucle à verrouillage de phase du synthétiseur de fréquence auxiliaire.

Selon un mode de réalisation, la fréquence F2 du signal auxiliaire est supérieure à la fréquence F1 du signal de sortie.

Selon un mode de réalisation, la fréquence F1 du signal de sortie est de l'ordre de 3 à 4 GHz.

Selon un mode de réalisation, la boucle à verrouillage de phase du synthétiseur de fréquence principal présente une bande passante comprise entre 1 et 30 MHz.

Selon un mode de réalisation, le pas en fréquence $\Delta F1$ du signal de sortie est de l'ordre de 400 KHz.

La présente invention concerne également un procédé pour réduire l'effet d'accrochage en fréquence dans un circuit intégré RF du type cité ci-dessus, comprenant l'utilisation, en tant que synthétiseur de fréquence, d'un synthétiseur de fréquence à effet de vernier comprenant un synthétiseur de fréquence auxiliaire fournissant un signal auxiliaire de fréquence F2 ajustable avec un pas en fréquence $\Delta F2$, et un synthétiseur de fréquence principal fournissant le signal de sortie de fréquence F1 et comprenant une boucle à verrouillage de phase comportant des moyens de mélange du signal de sortie de fréquence F1 avec le signal auxiliaire de fréquence F2, de sorte que le pas en fréquence $\Delta F1$ du signal de sortie est égal ou proportionnel au pas en fréquence $\Delta F2$ du signal auxiliaire, et dans lequel la bande passante de la première boucle à verrouillage de phase est choisie au moins deux fois supérieure au pas en fréquence $\Delta F2$ du signal auxiliaire.

Selon un mode de réalisation, l'écart entre les fréquences F2 et F1 est choisi supérieur à quelques dizaines de fois la fréquence de bande de base $F_{BB}$.

Selon un mode de réalisation, le synthétiseur de fréquence principal comprend un oscillateur contrôlé en tension fournissant le signal de sortie de fréquence F1, et un comparateur de phase recevant en entrée un signal de comparaison de fréquence déterminée et une composante soustractive de fréquence F2-F1 fournie par les moyens de mélange du signal de sortie de fréquence F1 avec le signal auxiliaire de fréquence F2.

Selon un mode de réalisation, la fréquence du signal de comparaison est choisie au moins 20 fois supérieure au pas en fréquence $\Delta F2$ du signal auxiliaire.

Selon un mode de réalisation, le signal de comparaison est obtenu par division par un nombre P de la fréquence F2 du signal auxiliaire, de sorte que le signal de sortie présente un pas en fréquence $\Delta F1$ égal au pas en fréquence $\Delta F2$ du signal auxiliaire multiplié par un terme qui est fonction de P.

Selon un mode de réalisation, la fréquence F2-F1 de la composante soustractive est de l'ordre de 300 MHz.

Selon un mode de réalisation, la fréquence F2 du signal auxiliaire est choisie supérieure à la fréquence F1 du signal de sortie.

Selon un mode de réalisation, la fréquence F1 du signal de sortie est de l'ordre de 3 à 4 GHz.

Selon un mode de réalisation, la boucle à verrouillage de phase du synthétiseur de fréquence principal présente une bande passante comprise entre 1 et 30 MHz.

Selon un mode de réalisation, le pas en fréquence $\Delta F1$ du signal de sortie est de l'ordre de 400 KHz.

Ces objets, caractéristiques et avantages ainsi que d'autres de la présente invention seront exposés plus en détail dans la description suivante d'un exemple de réalisation d'un synthétiseur de fréquence selon l'invention, faite à titre non limitatif en relation avec les figures jointes parmi lesquelles :

- la figure 1 précédemment décrite représente un synthétiseur de fréquence classique couplé à un circuit d'émission RF,
- la figure 2 précédemment décrite représente un synthétiseur de fréquence classique dont le signal de sortie est fourni par un mélangeur,
- la figure 3 précédemment décrite représente un autre synthétiseur de fréquence classique dont le signal de sortie est fourni par un mélangeur,
- la figure 4 représente diverses courbes de réjection d'un signal parasite pour diverses valeurs de bande passante d'une boucle à verrouillage de phase,
- la figure 5 représente un synthétiseur de fréquence selon l'invention, piloté par un signal auxiliaire fourni par un synthétiseur de fréquence auxiliaire, et
- la figure 6 représente une variante de réalisation du synthétiseur de fréquence de la figure 5.

Les courbes R1, R2, R3 représentées sur la figure 4 sont les fonctions de transfert de trois boucles à verrouillage de phase ayant des bandes passantes respectives de 0-30KHz, 0-60KHz, et 0-100 KHz. Ces fonctions de transfert représentent le niveau de signaux parasites en sortie d'un synthétiseur de fréquence 10 du type décrit plus haut en relation avec la figure 1, les signaux parasites étant émis par le modulateur QAM (circuit TXCT) .

L'axe horizontal est gradué en fréquence différentielle dF selon une échelle logarithmique, soit la différence entre la fréquence du signal parasite et la fréquence centrale de l'oscillateur contrôlé en tension. L'axe vertical est gradué en niveau relatif selon une échelle logarithmique, soit le rapport entre le niveau du signal à la fréquence considérée et le niveau du signal à la fréquence centrale de l'oscillateur contrôlé en tension.

La droite de pente négative représentée en traits pointillés représente la fonction de transfert de l'oscillateur seul, sans la boucle à verrouillage de phase. Cette fonction de transfert est décroissante quand dF augmente. La différence entre la droite en traits pointillés et les courbes R1, R2, R3 est représentative de la réjection du signal parasite assurée par la boucle de verrouillage par rapport à l'oscillateur seul. Le taux de réjection diminue quand dF augmente jusqu'à s'annuler quand dF est égale à la bande passante de la boucle à verrouillage.

En comparant les courbes R1, R2, R3, on observe que plus la bande passante est large plus le niveau maximum des parasites diminue. On observe également que, pour une fréquence différentielle dF donnée, le niveau des signaux parasites diminue quand la bande passante augmente.

La présente invention se fonde sur cette constatation et vise une structure de synthétiseur de fréquence qui permette de régler à une valeur élevée la bande passante d'une boucle à verrouillage de phase.

Plus particulièrement, la présente invention prévoit de remplacer, dans un circuit intégré RF du type décrit plus haut, le synthétiseur de fréquence classique par un synthétiseur de fréquence à effet de vernier, comprenant deux synthétiseurs de fréquence en cascade, et de conférer à l'un des synthétiseurs de fréquence une large bande passante de boucle.

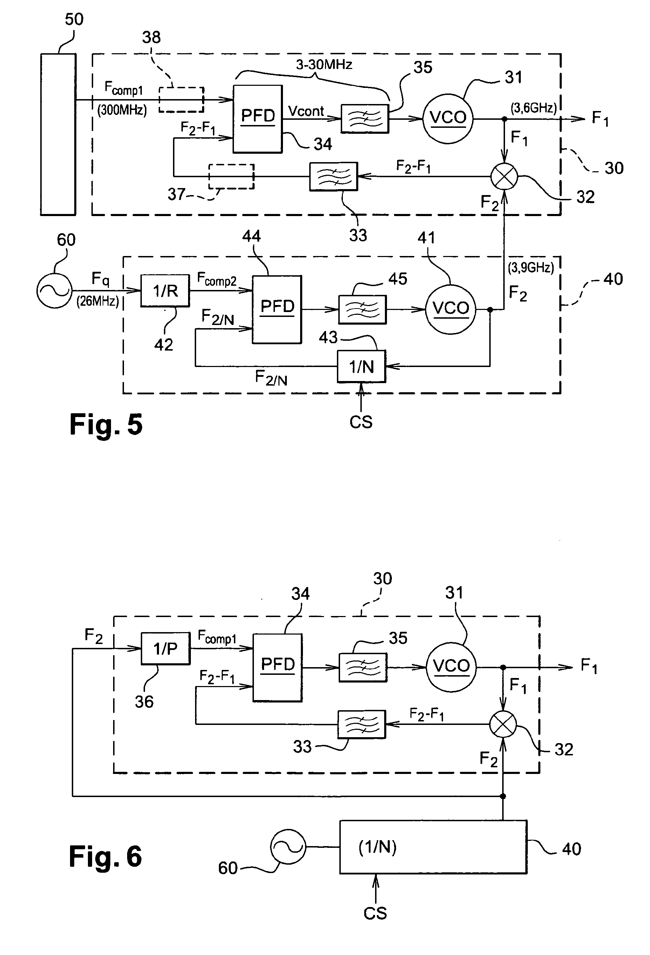

Un tel synthétiseur de fréquence à effet de vernier est représenté en figure 5 et comprend un synthétiseur de fréquence principal 30 et un synthétiseur de fréquence auxiliaire 40.

Le synthétiseur de fréquence 30 comprend un oscillateur contrôlé en tension 31 et une boucle à verrouillage de phase comprenant un mélangeur 32, un filtre 33, un comparateur de phase 34 et un filtre de boucle 35 de type passe-bas. L'oscillateur 31 fournit un signal de fréquence F1 qui forme le signal de sortie du synthétiseur de fréquence. Le comparateur de phase 34 reçoit sur une première entrée le signal de fréquence F1 et sur une seconde entrée un signal auxiliaire de fréquence F2 ajustable avec un pas en fréquence $\Delta$F2, fournit par le synthétiseur de fréquence auxiliaire 40. La sortie du mélangeur 32 fournit un signal de mélange comprenant une composante additive de fréquence F2+F1 et une composante soustractive de fréquence F2-F1. Le signal de mélange est appliqué au filtre 33, ici un filtre passe-bande prévu pour supprimer la composante additive. La sortie du filtre 33 fournit ainsi un signal de fréquence F2-F1 qui est appliqué sur une première entrée du comparateur de phase 34. Le comparateur de phase reçoit sur une seconde entrée un signal de comparaison de fréquence Fcomp1, fournit ici par un second circuit auxiliaire 50. La sortie du comparateur de phase fournit un signal de contrôle Vcont qui est appliquée à l'oscillateur 31 par l'intermédiaire du filtre de boucle 35.

L'équation de la boucle à verrouillage de phase du synthétiseur de fréquence 30 est la suivante :

$$F2-F1 = Fcomp1$$

soit :

$$F1 = F2 - Fcomp1$$

Pour obtenir une fréquence F1 de 3,6 GHz, Fcomp1 est par exemple égale à 300 MHz et F2 égale à 3,9 GHz.

Par ailleurs, les variations de la fréquence F2 se répercutent sur le signal F1 de la manière suivante, en supposant ici que la fréquence Fcomp1 est constante :

$$F1 + \Delta F1 = F2 + \Delta F2 - Fcomp1$$

soit :

$$F1 + \Delta F1 = F2 - Fcomp1 + \Delta F2$$

soit :

$$F1 + \Delta F1 = F1 + \Delta F2$$

soit :

$$\Delta F1 = \Delta F2$$

Ainsi, les variations de la fréquence auxiliaire F2 entraînent ici des variations similaires de la fréquence F1 du signal de sortie, ce qui caractérise l'effet de vernier.

L'avantage d'une telle structure de synthétiseur de fréquence est que la bande passante de la boucle à verrouillage de phase peut être choisie élevée en choisissant une fréquence de comparaison Fcomp1 élevée. Ainsi, si la fréquence de comparaison Fcomp1 est de 300 MHz suivant l'exemple cité ci-dessus, la bande passante de la boucle à verrouillage peut être choisie jusqu'à 30 MHz en appliquant la règle classique des 1/10. Une telle bande passante étendue, près de 1000 fois supérieure à la bande passante de la boucle à verrouillage de phase d'un synthétiseur de fréquence classique, confère à la boucle à verrouillage de phase un taux de réjection des signaux parasites nettement plus élevé qu'une boucle à verrouillage de phase classique.

Sur la figure 4, la courbe R4 représente la fonction de transfert de la boucle à verrouillage de phase selon l'invention. Celle-ci est de forme semblable à celles des courbes R1, R2, R3 mais se trouve décalée de -50 dB relativement à la courbe R1 dans la bande passante de modulation de l'oscillateur contrôlé en tension, soit un excellent taux de réjection permettant de diminuer de façon sensible l'effet d'accrochage en fréquence.

En pratique, des contraintes techniques en soi sans rapport avec la présente invention, peuvent conduire à choisir une bande passante de boucle plus faible que celle prévue par le calcul théorique. De telles contraintes techniques sont des règles dictées par des normes qui visent à supprimer, dans le signal de sortie, le bruit produit par certains éléments présents dans les synthétiseurs de fréquence (par exemple le bruit d'une pompe de charges présente dans le comparateur de phase). Ainsi, la bande passante de la boucle à verrouillage de phase pourra, en pratique, être calée au voisinage de 3 MHz au lieu d'être calée à 30 MHz. Toutefois, même dans ce cas, la bande passante de la boucle demeure près de 100 fois supérieure à la bande passante d'une boucle à verrouillage de phase classique, et le taux de réjection des signaux parasites demeure très élevé.

Le réglage de la bande passante de la boucle à verrouillage de phase selon l'invention est en soi une opération à la portée de l'homme de l'art. La bande passante de la boucle est fonction notamment de la bande passante et du coefficient d'atténuation du filtre de boucle 35, du gain du comparateur de phase 34 et du gain du mélangeur 32.

Comme représenté sur la figure 5, le synthétiseur de fréquence auxiliaire 40 est piloté par un oscillateur à quartz 60 et comprend un oscillateur contrôlé en tension 41, un diviseur de fréquence 42 de rang R et une boucle à verrouillage de phase. La boucle à verrouillage de phase comprend classiquement un diviseur de fréquence 43 de rang N, un comparateur de phase 44 et un filtre de boucle 45 passe-bas. Le rang N du diviseur de fréquence 43 est programmable au moyen d'un signal CS appliqué au diviseur de fréquence, qui permet de faire varier le nombre de pas en fréquence $\Delta$F2 que comprend la fréquence F2.

L'oscillateur 41 fournit le signal auxiliaire de fréquence F2. Le diviseur de fréquence 43 reçoit e le signal de fréquence F2 et fournit un signal de fréquence F2/N sur une entrée du comparateur de phase 44. Le comparateur de phase reçoit sur une autre entrée une fréquence de comparaison Fcomp2, fournie par le diviseur de fréquence 42 dont l'entrée reçoit un signal de fréquence Fq fourni par l'oscillateur 60. La sortie du comparateur de phase 44 fournit un signal de contrôle Vcont qui est appliqué à l'oscillateur 41 par l'intermédiaire du filtre de boucle 45. La fréquence F2 est ainsi égale à N*Fcomp2, Fcomp2 représentant le pas en fréquence $\Delta$F2 du signal auxiliaire.

Le second circuit auxiliaire 50, qui fournit le signal de comparaison de fréquence Fcomp1, peut également être un synthétiseur de fréquence de type classique. Toutefois, selon un mode de réalisation avantageux de l'invention, le signal de comparaison de fréquence Fcomp1 est produit au moyen du signal auxiliaire fourni par le synthétiseur de fréquence auxiliaire 40.

La figure 6 représente un tel mode de réalisation. Le synthétiseur de fréquence 30 comprend, en sus des éléments décrits ci-dessus, un diviseur 36 de rang P dont l'entrée reçoit le signal auxiliaire. La sortie du diviseur 36 fournit le signal de comparaison dont la fréquence Fcomp1 est ici égale à F2/P. L'équation de la boucle à verrouillage de phase s'écrit alors :

$$F2-F1 = F2/P$$

soit :

$$F1 = F2 \left( (P-1)/P \right)$$

Dans ces conditions, les variations de la fréquence F2 se répercutent sur le signal F1 de la manière suivante :

$$F1 + \Delta F1 = (F2 + \Delta F2)((P-1)/P)$$

soit :

$$F1 + \Delta F1 = F2 \left( (P-1)/P \right) + \Delta F2 \left( (P-1)/P \right)$$

soit :

$$F1 + \Delta F1 = F1 + \Delta F2 ((P-1)/P)$$

soit :

$$\Delta F1 = \Delta F2 ((P-1)/P)$$

Ainsi, ici, les variations de la fréquence auxiliaire F2 entraînent des variations proportionnelles de la fréquence F1 du signal de sortie, dans un rapport égal à (P-1)/P.

Le pas en fréquence $\Delta$F2 du synthétiseur de fréquence auxiliaire 40 est choisi en fonction du pas en fréquence $\Delta$F1 souhaité pour le signal de sortie du synthétiseur de fréquence 30 :

$$\Delta F2 = \Delta F1 * 1/((P-1)/P))$$

soit :

$$Fq/R = \Delta F1 * 1/ ( (P-1) /P) )$$

Ainsi, le rang R du diviseur 36 est choisi de manière que :

$$R = Fq/\Delta F1 ((P-1)/P))$$

A titre d'exemple numérique, les valeurs suivantes peuvent être choisies :

Fq = 26 MHz
F1 = 3,6 GHz (valeur centrale de la bande F1)
$\Delta$F1 = 400 KHz
F2 = 3,9 GHz (valeur centrale de la bande F2)
Fcomp1 = F2-F1 = 300 MHz
P = 13

Il vient que :

R = Fq/$\Delta$F1 ((P-1)/P)) = 60
Fcomp2 = $\Delta$F2 = Fq/R = 433 KHz
N = 3,9 GHz/433 KHz = 9006 (valeur centrale de N)

La boucle à verrouillage de phase du synthétiseur de fréquence auxiliaire 40 présente une bande passante de l'ordre du dixième de la fréquence Fcomp2, et n'est donc pas immunisée contre des signaux parasites pouvant se trouver au voisinage de la fréquence centrale de l'oscillateur 41. Toutefois, l'immunité du synthétiseur de fréquence auxiliaire 40 est obtenue ici par le fait que la fréquence auxiliaire F2 est décalée relativement à la fréquence F1 du signal de sortie. Ainsi, si des signaux harmoniques de fréquence F1 + 2$F_{BB}$ ($F_{BB}$ étant la fréquence de la bande de base) sont réinjectés dans le synthétiseur de fréquence auxiliaire 40, ces signaux se trouvent en dehors de la plage d'amplification de l'oscillateur 41. Une telle immunité nécessite une précaution minimale dans le choix de la fréquence F2, qui doit être tel que l'écart entre les fréquences F2 et F1 soit au moins supérieur à quelques dizaines de fois la bande de base. Dans l'exemple donné ci-dessus, l'écart entre F2 et F1 est de 300 MHz et est donc plus de 1000 fois supérieur à la bande de base, qui est généralement de l'ordre de 200 KHz. Le synthétiseur de fréquence auxiliaire 40 est donc totalement immunisé contre des composantes harmoniques du signal de sortie du synthétiseur de fréquence 30.

Il apparaîtra clairement à l'homme de l'art que la présente invention est susceptible de diverses variantes de réalisation et de diverses applications. Notamment, comme représenté en traits pointillés sur la figure 5, deux diviseurs 37, 38 de même rang D peuvent être ajoutés au synthétiseur de fréquence 30. Le diviseur 37 est agencé entre la sortie du filtre 33 et la première entrée du comparateur de phase 34. Le diviseur 38 reçoit le signal Fcomp1 et sa sortie est reliée à la seconde entrée du comparateur de phase 34.

**Revendications**

1. Circuit intégré RF comprenant un synthétiseur de fréquence et un modulateur QAM (TXCT) pour moduler un signal de bande de base de fréquence $F_{BB}$, le synthétiseur de fréquence fournissant au modulateur QAM un signal de sortie de fréquence F1 ajustable avec un pas en fréquence $\Delta$F1, pour former un signal de porteuse du modulateur QAM, **caractérisé en ce que** le synthétiseur de fréquence est un synthétiseur de fréquence à effet de vernier comprenant :

   - un synthétiseur de fréquence auxiliaire (40) fournissant un signal auxiliaire de fréquence F2 ajustable avec un pas en fréquence $\Delta$F2, et
   - un synthétiseur de fréquence principal (30) fournissant le signal de sortie de fréquence F1 et comprenant une boucle à verrouillage de phase (32, 33, 34, 35) comportant des moyens (32, 33) de mélange du signal de sortie de fréquence F1 avec le signal auxiliaire de fréquence F2, de sorte que le pas en fréquence $\Delta$F1 du signal de sortie est égal ou proportionnel au pas en fréquence $\Delta$F2 du signal auxiliaire,

   et **en ce que** la bande passante de la boucle à verrouillage de phase du synthétiseur de fréquence principal (30) est au moins deux fois supérieure au pas en fréquence $\Delta$F2 du signal auxiliaire.

2. Circuit intégré RF selon la revendication 1, dans lequel l'écart entre les fréquences F2 et F1 est supérieur à quelques dizaines de fois la fréquence de bande de base $F_{BB}$ .

3. Circuit intégré RF selon l'une des revendications 1 et 2, dans lequel le synthétiseur de fréquence principal (30) comprend un oscillateur contrôlé en tension (31) fournissant le signal de sortie de fréquence F1, et un comparateur de phase (34) recevant en entrée un signal de comparaison de fréquence déterminée (Fcomp1) et une composante soustractive de fréquence F2-F1 fournie par les moyens (32, 33) de mélange du signal de sortie de fréquence F1 avec le signal auxiliaire de fréquence F2.

4. Circuit intégré RF selon la revendication 3, dans lequel la fréquence (Fcomp1) du signal de comparaison est au moins 20 fois supérieure au pas en fréquence ΔF2 du signal auxiliaire.

**5.** Circuit intégré RF selon l'une des revendications 3 et 4, dans lequel le signal de comparaison est un signal de fréquence fixe, de sorte que le pas en fréquence ΔF1 du signal de sortie est égal au pas en fréquence ΔF2 du signal auxiliaire.

**6.** Circuit intégré RF selon l'une des revendications 3 et 4, dans lequel le synthétiseur de fréquence principal (30) comprend un diviseur de fréquence de rang P (36) recevant en entrée le signal auxiliaire et fournissant le signal de comparaison, de sorte que le signal de sortie présente un pas en fréquence ΔF1 égal au pas en fréquence ΔF2 du signal auxiliaire multiplié par un terme ((P-1)/P) qui est fonction de P.

**7.** Circuit intégré RF selon l'une des revendications 3 à 6, dans lequel la fréquence F2-F1 de la composante soustractive est de l'ordre de 300 MHz.

**8.** Circuit intégré RF selon l'une des revendications 1 à 7, dans lequel le synthétiseur de fréquence auxiliaire (40) comprend un oscillateur contrôlé en tension (41) et une boucle à verrouillage de phase (43, 44, 45), l'oscillateur contrôlé en tension du synthétiseur de fréquence auxiliaire fournissant le signal auxiliaire, la boucle à verrouillage de phase du synthétiseur de fréquence auxiliaire permettant d'ajuster la fréquence F2 du signal auxiliaire.

**9.** Circuit intégré RF selon la revendication 8, dans lequel le synthétiseur de fréquence auxiliaire est piloté par un oscillateur à quartz (60) relié à un diviseur de fréquence de rang R (42) qui fournit un signal de comparaison de fréquence déterminée (Fcomp2) à la boucle à verrouillage de phase du synthétiseur de fréquence auxiliaire (40).

**10.** Circuit intégré RF selon l'une des revendications 1 à 9, dans lequel la fréquence F2 du signal auxiliaire est supérieure à la fréquence F1 du signal de sortie.

**11.** Circuit intégré RF selon l'une des revendications 1 à 10, dans lequel la fréquence F1 du signal de sortie est de l'ordre de 3 à 4 GHz.

**12.** Circuit intégré RF selon l'une des revendications 1 à 11, dans lequel la boucle à verrouillage de phase du synthétiseur de fréquence principal (39) présente une bande passante comprise entre 1 et 30 MHz.

**13.** Circuit intégré RF selon l'une des revendications 1 à 12, dans lequel le pas en fréquence ΔF1 du signal de sortie est de l'ordre de 400 KHz.

**14.** Procédé pour réduire l'effet d'accrochage en fréquence dans un circuit intégré RF comprenant un synthétiseur de fréquence et un modulateur QAM (TXCT) pour moduler un signal de bande de base de fréquence $F_{BB}$, le synthétiseur de fréquence fournissant au modulateur QAM un signal de sortie de fréquence F1 ajustable avec un pas en fréquence ΔF1, pour former un signal de porteuse du modulateur QAM, l'effet d'accrochage en fréquence étant dû à l'injection dans le synthétiseur de fréquence de signaux parasites issus du modulateur QAM,

**caractérisé en ce qu'**il comprend l'utilisation, en tant que synthétiseur de fréquence, d'un synthétiseur de fréquence à effet de vernier comprenant :

- un synthétiseur de fréquence auxiliaire (40) fournissant un signal auxiliaire de fréquence F2 ajustable avec un pas en fréquence ΔF2, et
- un synthétiseur de fréquence principal (30) fournissant le signal de sortie de fréquence F1 et comprenant une boucle à verrouillage de phase (32, 33, 34, 35) comportant des moyens (32, 33) de mélange du signal de sortie de fréquence F1 avec le signal auxiliaire de fréquence F2, de sorte que le pas en fréquence ΔF1 du signal de sortie est égal ou proportionnel au pas en fréquence ΔF2 du signal auxiliaire,

et **en ce que** la bande passante de la première boucle à verrouillage de phase est choisie au moins deux fois supérieure au pas en fréquence ΔF2 du signal auxiliaire.

**15.** Procédé selon la revendication 14, dans lequel l'écart entre les fréquences F2 et F1 est choisi supérieur à quelques dizaines de fois la fréquence de bande de base $F_{BB}$ .

**16.** Procédé selon l'une des revendications 14 et 15, dans lequel le synthétiseur de fréquence principal (30) comprend un oscillateur contrôlé en tension (31) fournissant le signal de sortie de fréquence F1, et un comparateur de phase (34) recevant en entrée un signal de comparaison de fréquence déterminée (Fcomp1) et une composante soustractive de fréquence F2-F1 fournie par les moyens (32, 33) de mélange du signal de sortie de fréquence F1 avec le signal auxiliaire de fréquence F2.

**17.** Procédé selon la revendication 16, dans lequel la fréquence (Fcomp1) du signal de comparaison est choisie au moins 20 fois supérieure au pas en fréquence ΔF2 du signal auxiliaire.

**18.** Procédé selon l'une des revendications 16 et 17, dans lequel le signal de comparaison est obtenu par division par un nombre P de la fréquence F2 du signal auxiliaire, de sorte que le signal de sortie présente un pas en fréquence ΔF1 égal au pas en fréquence ΔF2 du signal auxiliaire multiplié par un terme ((P-1)/P) qui est fonction de P.

**19.** Procédé selon l'une des revendications 16 à 18, dans lequel la fréquence F2-F1 de la composante soustractive est de l'ordre de 300 MHz.

**20.** Procédé selon l'une des revendications 14 à 19, dans lequel la fréquence F2 du signal auxiliaire est choisie supérieure à la fréquence F1 du signal de sortie.

**21.** Procédé selon l'une des revendications 14 à 20, dans lequel la fréquence F1 du signal de sortie est de l'ordre de 3 à 4 GHz.

**22.** Procédé selon l'une des revendications 14 à 21, dans lequel la boucle à verrouillage de phase du synthétiseur de fréquence principal présente une bande passante comprise entre 1 et 30 MHz.

**23.** Procédé selon l'une des revendications 14 à 22, dans lequel le pas en fréquence ΔF1 du signal de sortie est de l'ordre de 400 KHz.

**Fig. 1**

**Fig. 2**

**Fig. 3**

**Fig. 4**

**Fig. 5**

**Fig. 6**

**Office européen des brevets**

**RAPPORT DE RECHERCHE EUROPEENNE**

Numéro de la demande

EP 04 02 9810

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| Y | WO 01/01562 A (HEINEN STEFAN ; DETERING VOLKER (DE); SIEMENS AG (DE)) 4 janvier 2001 (2001-01-04) * page 1, ligne 22 - page 2, ligne 2 * * page 9, ligne 16 - page 10, ligne 24 * * page 12, ligne 6 - page 13, ligne 28 * * figures 1,5,8-10 * ----- | 1-5, 7-17, 19-23 | H03L7/23 H04L27/36 |
| Y | US 5 717 730 A (ROTZOLL ROBERT RUDOLF ET AL) 10 février 1998 (1998-02-10) * colonne 1, ligne 49 - colonne 2, ligne 8 * * colonne 2, ligne 62 - colonne 3, ligne 57 * * figure 1 * ----- | 1-5, 7-17, 19-23 | |
| Y | US 5 434 887 A (OSAKA MASAHIKO) 18 juillet 1995 (1995-07-18) * colonne 1, ligne 5 - ligne 20 * * colonne 1, ligne 40 - ligne 43 * * colonne 1, ligne 55 - colonne 2, ligne 2 * * colonne 2, ligne 45 - colonne 4, ligne 44 * * figures 2-6 * ----- | 1-5, 7-17, 19-23 | |

**DOMAINES TECHNIQUES RECHERCHES (Int.Cl.7)**

H03L
H04B
H04L

Le présent rapport a été établi pour toutes les revendications

| Lieu de la recherche | Date d'achèvement de la recherche | Examinateur |
|---|---|---|
| La Haye | 18 avril 2005 | Balbinot, H |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 04 02 9810

La présente annexe indique les membres de la  famille de brevets relatifs aux documents  brevets cités dans le rapport de
recherche européenne visé ci-dessus.
Lesdits members sont contenus au fichier informatique de l'Office  européen des brevets à la date du
Les renseignements fournis sont donnés à titre  indicatif et n'engagent pas la responsabilité  de l'Office européen des brevets.

18-04-2005

| Document brevet cité au rapport de recherche | | Date de publication | Membre(s) de la famille de brevet(s) | | Date de publication |
|---|---|---|---|---|---|
| WO 0101562 | A | 04-01-2001 | DE | 19928998 A1 | 02-08-2001 |
| | | | CA | 2377790 A1 | 04-01-2001 |
| | | | CN | 1370347 A ,C | 18-09-2002 |
| | | | WO | 0101562 A1 | 04-01-2001 |
| | | | DE | 50006416 D1 | 17-06-2004 |
| | | | EP | 1188228 A1 | 20-03-2002 |
| | | | ES | 2220483 T3 | 16-12-2004 |
| | | | HK | 1048713 A1 | 25-02-2005 |
| | | | JP | 2003503930 T | 28-01-2003 |
| | | | US | 6850121 B1 | 01-02-2005 |
| US 5717730 | A | 10-02-1998 | AUCUN | | |
| US 5434887 | A | 18-07-1995 | CA | 2104729 A1 | 26-02-1994 |
| | | | JP | 6224958 A | 12-08-1994 |

EPO FORM P0460

Pour tout renseignement concernant cette annexe :  voir Journal Officiel de l'Office européen des  brevets, No.12/82